Europäisches Patentamt

European Patent Office

Office européen des brevets

(19)

(11) Veröffentlichungsnummer : **0 386 047 B1**

(12) **EUROPÄISCHE PATENTSCHRIFT**

(45) Veröffentlichungstag der Patentschrift :
01.07.92 Patentblatt 92/27

(51) Int. Cl.⁵ : **C30B 15/08, C30B 15/34**

(21) Anmeldenummer : **88909313.4**

(22) Anmeldetag : **17.10.88**

(86) Internationale Anmeldenummer :
**PCT/EP88/00929**

(87) Internationale Veröffentlichungsnummer :
**WO 89/03902 05.05.89 Gazette 89/10**

(54) **VERFAHREN UND VORRICHTUNG ZUR HERSTELLUNG VON EINKRISTALLINEN HALBLEITERPLATTEN.**

(30) Priorität : **20.10.87 DE 3735434**

(43) Veröffentlichungstag der Anmeldung :
**12.09.90 Patentblatt 90/37**

(45) Bekanntmachung des Hinweises auf die Patenterteilung :
**01.07.92 Patentblatt 92/27**

(84) Benannte Vertragsstaaten :
**DE GB**

(56) Entgegenhaltungen :
**EP-A- 0 053 810**
**DE-A- 2 554 354**
**DE-A- 2 745 335**
**US-A- 4 334 948**

(73) Patentinhaber : **WISOTZKI, Jürgen**
**Weserstrasse 7a**
**W-6074 Rödermark (DE)**

(72) Erfinder : **WISOTZKI, Jürgen**
**Weserstrasse 7a**
**W-6074 Rödermark (DE)**

(74) Vertreter : **Jochem, Bernd, Dipl.-Wirtsch.-Ing.**
**Patentanwälte Beyer & Jochem Postfach 17 01 45**
**W-6000 Frankfurt/Main (DE)**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zur Herstellung von einkristallinen Halbleiterplatten, z. B. Wafern, durch Züchtung eines Einkristalls mittels eines Impfkristalls aus einer Schmelze und Abtrennung der einzelnen Halbleiterplatten von dem Einkristall, wobei die Schmelze in einem unterhalb ihrer Oberfläche über eine Einlaßöffnung an einen Schmelztiegel angeschlossenen, in Längsrichtung glattwandigen Formschacht zur Kristallisation gebracht und der gebildete Einkristall weiter wachsend im Formschacht vorgeschoben und jeweils im Abstand der Länge einer Außenkante der Halbleiterplatten quer zur Vorschubrichtung durchgetrennt wird.

Die Herstellung von Halbleiterplatten, insbesondere von Wafern aus Silicium oder Germanium, hat für die Fertigung elektronischer Bauelemente große Bedeutung. Bisher werden die Wafer in der Weise gewonnen, daß nach der Czochralski-Methode ein Impfkristall in die Schmelze eines Tiegels eingetaucht und unter langsamer Drehung wieder herausgezogen wird, wobei Einkristalle in zylindrischer Form mit mehreren Zentimetern Durchmesser und Länger von bis zu einem Meter gezogen werder. Man unternimmt bei diesem Verfahrensschritt maschinell und apparativ die größten Anstrengungen, um möglichst perfekte Einkristalle zu erhalten. Dann aber werden die so gewonnenen Einkristallrohlinge zu Scheiben bzw. Platten zersägt, was dazu führt, daß deren Oberflächen weitgehend in die Tiefe der Oberflächenkristallstruktur zerstört werden. Schonendste Trennmethoden haben immer noch eine Zerstörtiefe von ca. 200 μm. Bei einem Gitterabstand von z. B. bei Silicium 6,64 Angstrom (664 pm) bedeutet dies eine Zerstörung von ca. 30.000 Atomlagen.

Nach den genannten Arbeitsgängen ist der mühsam gezüchtete Einkristall somit wieder nachhaltig zerstört und als Halbleiterelement nicht verwendbar. Erst durch eine sehr aufwendige Bearbeitung mittels Schleifen, Polieren, Ätzen und nochmaliges Polieren wird versucht, an den Oberflächen der durch Sägen gebildeten Halbleiterplatten wieder eine gebrauchsfähige Kristallstruktur zu erzeugen. Dabei sind fortlaufend röntgenographische Topographieaufnahmen erforderlich, um die ausgeheilten bzw. gebrauchsfähigen Kristallzonen festzustellen.

Es ist aus der DE-A-2 554 354 auch bereits bekannt, im Prinzip nach der Czochralski-Methode ein einkristallines Band über einen Spalt, welcher die Form eines Schachts haben kann, der unterhalb der Oberfläche der Schmelze über eine Einlaßöffnung an einen Schmelztiegel angeschlossen ist, aus der Schmelze zu ziehen. Die Schmelze bildet dabei zu dem Einkristall hin, der aus ihr herausgezogen wird, einen Meniskus, der sich von der Wand des Spalts löst, so daß die Formgebung der Oberfläche des festen Einkristalls nicht in Anlage an der Wand des Schachts, sondern frei im Raum der umgebenden Atmosphäre stattfindet. Gleichmäßigkeit der Formgebung des Einkristalls wird durch geeignete Steuerung des Drucks der Schmelze angestrebt. Damit lassen sich jedoch nicht alle Zufälligkeiten des Kristallwachstums aus dem Meniskus frei im Raum beherrschen.

Der Erfindung liegt die Aufgabe zugrunde, ein einfaches Verfahren zur Herstellung von einkristallinen Halbleiterplatten mit sehr gleichmäßiger, gebrauchsfähiger Oberflächenkristallstruktur zu schaffen, und zur Lösung dieser Aufgabe wird vorgeschlagen, daß die Schmelze im Bereich zwischen der Einlaßöffnung und der Kristallisationszone im Formschacht auf eine höhere Temperatur als an der Einlaßöffnung erhitzt wird und die Breite des Formschachts gleich der Dicke der Halbleiterplatten ist.

Das erfindungsgemäße Verfahren ist im Prinzip ein Zonenschmelzverfahren, ausgeführt in einem Formschacht und mittels einer Hochfrequenzspule mit Konzentrator, so daß man einen verhältnismäßig großen Temperaturgradienten im Formschacht und eine glättende Formgebung der Oberfläche des Kristalls durch die Innenwand des Formschachts erhält. Die nach dem Verfahren erzeugten Halbleiterplatten sind auf ihren Oberflächen so ebenmäßig wie die glattwandigen Innenflächen des Formschachts in demjenigen Bereich, in welchem die durch Abkühlung herbeigeführte Kristallisation der Schmelze zum Einkristall stattfindet. Der entscheidende Oberflächenbereich des Formschachts sollte deshalb bis zu optischer Güte feinstbearbeitet sein. Entsprechend eben wird dann auch die an diesen Schachtwänden geformte Oberfläche des plattenförmig wachsenden Einkristalls, der bei diesem Herstellungsverfahren von vornherein bis in die oberste Atomlage der gewachsenen Platten eine unzerstörte Einkristallstruktur hat.

Theoretisch bestünde die Möglichkeit, den im Kristallisationsbereich wirksamen statischen Druck der Schmelze durch die Höhe des Flüssigkeitsspiegels so zu steuern, daß der im Formschacht gebildete Einkristall kontinuierlich von der Schmelze fort vorgeschoben wird. Vorzugsweise wird jedoch die Vorschubgeschwindigkeit durch Zurückziehen einer Halterung des Impfkristalls in Richtung von der Schmelze weg gesteuert. Nach dem Abtrennen des Impfkristalls und einer oder mehrerer fertiger Platten erfolgt dann in entsprechender Weise die Steuerung der Vorschubgeschwindigkeit durch Zurückziehen der Halterung, welche jetzt an Stelle des Impfkristalls das äußere Ende des Einkristalls hält. Bei dieser Art der Steuerung wirken nicht nur der statische Druck der Schmelze und das Eigengewicht des Einkristalls in Vorschubrichtung auf diesen, sondern es kann über die Halterung des Impfkristalls zusätzlich eine Zugkraft auf den Einkristall ausgeübt werden, um die Reinung an den formenden Innenflächen des Formschachts zu überwinden. Diese Reibung tritt praktisch nur im Kristallisationsbereich auf, da der Einkristall auf seinem Vorschubweg weiter abkühlt und von der vorzugsweise prismatischen Innenwand des Formschachts wegschrumpft.

Im Gegensatz zum Czochralski-Verfahren findet bei dem erfindungsgemäßen Verfahren die Bildung des Einkristalls nicht oberhalb, sondern unterhalb des Flüssigkeitsspiegels der Schmelze statt. Daher kann es schwierigkeiten bereiten, am Anfang des Fertigungsprozesses den Impfkristall von unten in die Schmelze "einzutauchen". Es hat sich jedoch überraschend gezeigt, daß auch dieses Problem gelöst werden kann, indem vor Beginn eines Kristallisationsvorgangs die Schmelze an einer Einlaßöffnung in den Formschacht derart unterkühlt wird, daß sie durch ihre Oberflächenspannung dort zurückgehalten wird, bis sie mit dem Impfkristall in Berührung kommt.

Um beim Heranfahren des Impfkristalls durch den Formschacht hindurch an die unterkühlte Schmelze an der Einlaßöffnung kein Gasvolumen im Formschacht einzuschließen und außerdem den Vorgang der Kontaktierung beobachten zu können, ist in weiterer bevorzugter Ausgestaltung der Erfindung vorgesehen, daß die Schmelze über eine seitliche Einlaßöffnung in einen oberhalb derselben offenen, im wesentlichen senkrecht ausgerichteten Formschacht eingeführt wird. In diesem zusammenhang wird in weiterer bevorzugter Ausführung der Erfindung die Schmelze im Bereich zwischen der Einlaßöffnung und der Kristallisationszone im Formschacht auf eine höhere Temperatur als an der Einlaßöffnung erhitzt. Auf diese Weise kann wiederum erreicht werden, daß die Oberflächensnannung die Schmelze daran hindert, im Formschacht oberhalb der Einlaßöffnung aufzusteigen. Im übrigen wäre dies nach der Einführung des Impfkristalls und der Kontaktierung mit der unterkühlten Schmelze für den weiteren Verlauf der Kristallisation im Formschacht unterhalb der Einlaßöffnung unerheblich.

Im Interesse einer wirtschaftlichen Fertigung der Halbleiterplatten wird weiterhin vorgeschlagen, daß wenigstens zwei jeweils durch eine Zwischenwand getrennte Einkristalle gleichzeitig gezüchtet werden. Der apparative Aufwand für die Beheizung der Schmelze und die Steuerung der Einkristalle ist nämlich bei der vorgeschlagenen Art des Ziehens von Einkristallen praktisch derselbe, unabhängig davon, ob ein oder mehrere parallele Einkristalle gezogen werden.

Auch die Art und Weise, wie bei der Fertigung von Halbleiterplatten mit einer bestimmten Kristallorientierung auf solche aus gleichem Material, aber mit einer anderen Kristallorientierung übergangen wird, kann für die Wirtschaftlichkeit eines Verfahrens von Bedeutung sein. In Ergänzung der vorliegenden Erfindung wird hierzu vorgeschlagen, daß nach dem Abtrennen einer Halbleiterplatte zum Übergang auf die Herstellung von Halbleiterplatten mit anderer Kristallorientierung der mit der Schmelze in Berührung stehende Teil des Einkristalls über einen gegen sein äußeres Ende drückenden Impfkristall mit anderer Kristallorientierung im Formschacht rückwärts durch die Kristallisationszone hindurch in die Schmelze geschoben und wieder aufgeschmolzen wird.

Die zur Durchführung des neuen Verfahrens vorgeschlagene Vorrichtung hat einen Schmelztiegel, an dem unterhalb der Oberfläche der Schmelze über eine Einlaßöffnung wenigstens ein in Längsrichtung glattwandiger Formschacht angeschlossen ist, in welchem eine Halterung für einen Impfkristall vom offenen Ende zum Schmelztiegel hin vorschiebbar und zurückziehbar ist, und ist dadurch gekennzeichnet, daß der Formschacht durch eine Hochfrequenzspule mit einem zwischen der Einlaßöffnung und der Kristallisationszone angeordneten Konzentrator auf eine höhere Temperatur als an der Einlaßöffnung beheizbar ist. Zweckmäßigerweise ist der Formschacht im wesentlichen senkrecht ausgerichtet und oberhalb der seitlich angeordneten Einlaßöffnung zur umgebenden Atmosphäre offen. Die umgebende Atmosphäre besteht vorzugsweise aus einem Edelgas, z. B. Argon, als Schutzgas. In weiterer bevorzugter Ausführung der Erfindung erstreckt sich der Formschacht oberhalb der Einlaßöffnung bis über die Oberfläche der Schmelze nach oben, und zwar wenigstens im Falle zweier unmittelbar nebeneinander parallel angeordneter Formschächte durch den beiden gemeinsamen Schmelztiegel hindurch. Vorzugsweise sind auch beide Formschächte durch eine gemeinsame Hochfrequenzspule beheizbar.

Eine besonders kostengünstig herzustellende Vorrichtung zur Durchführung des erfindungsgemäßen Verfahrens bei der Herstellung von Siliciumplatten ist dadurch gekennzeichnet, daß die Innenwand des Schmelztiegel aus Quarz und die Innenwand des Formschachts wenigstens im Bereich der Kristallisationszone aus einem Edelmetall besteht.

Ausführungsbeispiele erfindungsgemäßer Vorrichtungen werden nachstehend anhand der Zeichnung näher erläutert. Es zeigen:

Fig. 1 in vereinfachter Darstellung einer senkrechten Schnitt durch einen Schmelztiegel und einen sich daran nach unten anschliessenden Formschacht;

Fig. 2 eine perspektivische Darstellung einer Vorrichtung nach Fig. 1, jedoch mit zwei Formschächten;

Fig. 3 eine graphische Darstelllung des Temperaturverlaufs im Formschacht.

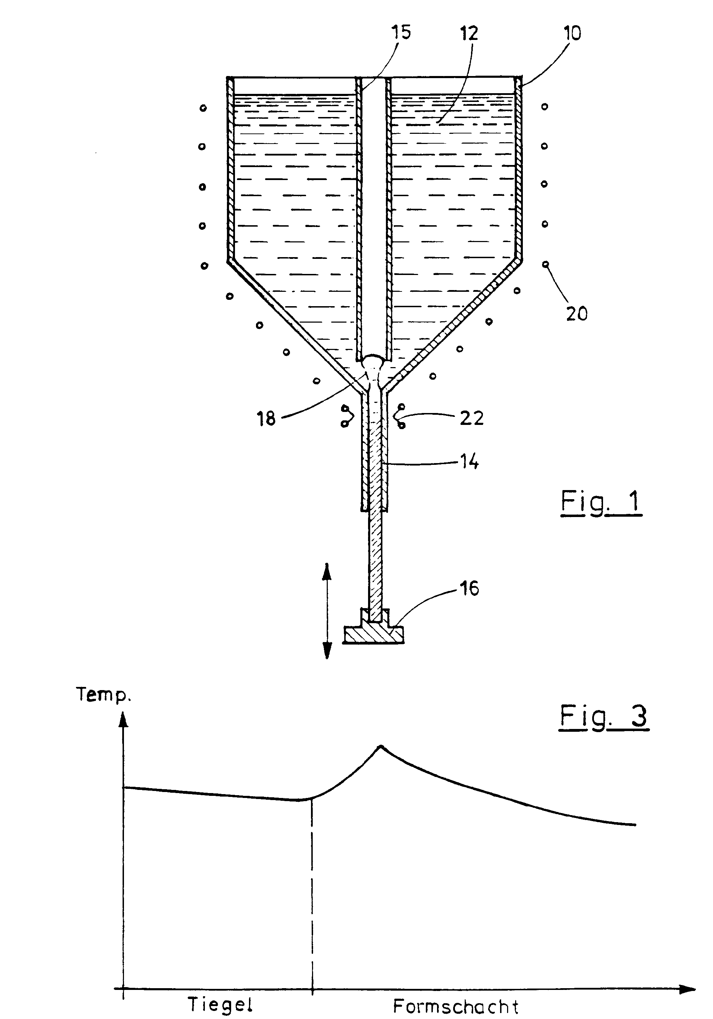

Die in Fig. 1 dargestellte Vorrichtung hat einer Schmelztiegel 10, welcher das Schmelzgut 12, z. B. Silicium, oder Germanium oder ein anderes Halbleitermaterial im geschmolzenen Zustand aufnimmt. Unten schließt sich an den Boden des Schmelztiegels 10 ein Formschacht 14 an. Dieser hat einen prismatischen Querschnitt mit einer lichten inneren Weite entsprechend der Dicke der herzustellenden Halbleiterplatten, einer quer zur Zeichenebene gemessenen Länge von z. B. 10 cm und einer Höhe von z. B. etwa 20 cm. Unterhalb des senkrechten Formschachts 14 ist eine Halterung 16 angeordnet, die zunächst einen Impfkristall, später das äußere Ende eines gebildeten Einkristalls axial abstützen, aber auch so halten kann, daß darauf eine nach unten wirkende Zugkraft ausgeübt werden kann. Die Halterung 16 ist so auszuführen, daß sie mit dem den Impfkristall tragenden Teil sehr genau in den Formschacht 14 paßt und soweit von unten nach oben in den Formschacht eingeführt werden kann, daß ein mit der Halterung 16 verbundener Impfkristall durch den Formschacht 14 hindurch bis an die Schmelze 12 im Tiegel 10 herangeführt werden kann.

Bei der gezeigten Ausführungsform erstreckt sich der Formschacht 14 mit einem oberen Verlängerungteil 15 durch den Schmelztiegel 10 hindurch bis mindestens zur Oberfläche der Schmelze 12. Der obere Verlängerungteil 15 des Formschachts kann einen größeren oder kleineren Querschnitt als der sich unten and den Schmelztiegel 10 anschließende Teil des Formschachts 14 haben.

Der Schmelztiegel 10 steht mit dem Formschacht 14 über gegenüberliegende seitliche Einlaßöffnungen 18 in Verbindung. Diese Einlaßöffnungen befinden sich im Beispielsfall am Boden des Schmelztiegels 10. Sie erstrecken sich normal zur Zeichenebene über die ganze Breite des Formschachts 14 und haben eine Höhe von z. B. etwa 1 - 5 mm. Sie könnten auch Zwischenstege haben.

Der Schmelztiegel 10 und der obere Bereich des Formschachts 14 werden durch eine Hochfrequenzspule 20 beheizt, die nahe dem Ansatz des Formschachts 14 an den Schmelztiegel 10 einen bei 22 angedeuteten Konzentrator aufweist.

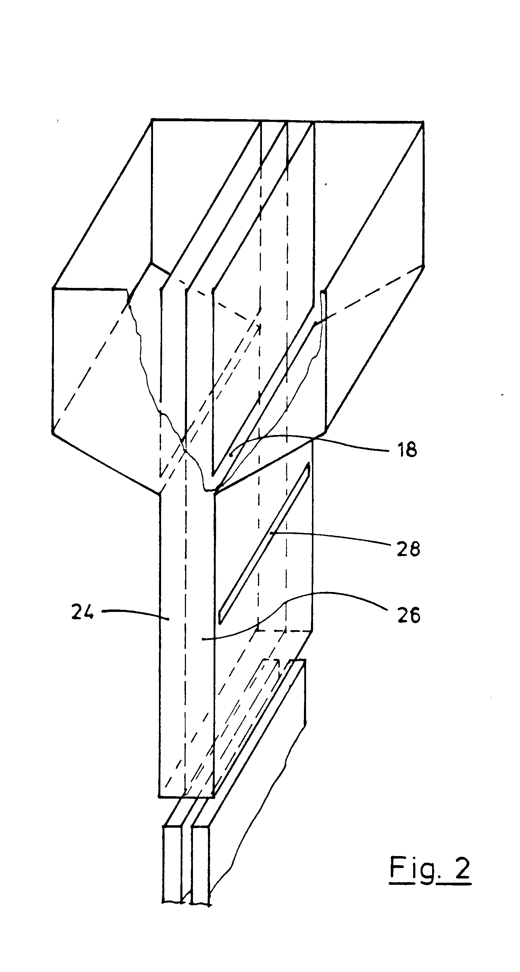

Die in Fig. 2 in Perspektive gezeigte Vorrichtung entspricht in ihrem Aufbau der Vorrichtung nach Fig. 1. sie unterscheidet sich nur dadurch von der letzteren, daß zwei Formschächte 24, 26 unmittelbar nebeneinander angeordnet sind, die jeweils nur auf einer Seite eine Einlaßöffnung 18 haben. Somit können in beiden Formschächten 24 und 26 einkristalline Halbleiterplatten gleichzeitig gezogen werden.

Bei beiden Ausführungen nach Fig. 1 und 2 besteht der Schmelztiegel 10 und wenigstens der beheizte obere Teil des Formschachts 14 bzw. 24, 26 aus einem äußeren Mantel, z. B. aus Graphit oder einem anderen durch die Hochfrequenzspule 20 aufheizbaren Material sowie gegebenenfalls einer inneren Auskleidung, die sich nach den Eigenschaften des Halbleitermaterials im geschmolzenen Zustand und beim Kristallisieren richtet. Im. Falle von Silicium als Halbleitermateriat kann die innere Auskleidung im Bereich der Schmelze z. B. aus Quarz oder einem Edelmetall bestehen, während im Bereich der Kristallisationszone im Formschacht 14 bzw. 24, 26 nur eine Beschichtung der Innenwand mit einem Edelmetall in Frage kommt. Grundsätzlich können je nach zu schmelzendem Halbleitermaterial auch einschichtige Schmelztiegelund Formschächte in Frage kommen, wobei es dem Fachmann nicht schwerfällt, im Einzelfall die Materialien der Wandungen so zu wählen, daß keine Reaktion mit dem Halbleitermaterial stattfindet und eine funktionsgerechte Beheizung ermöglicht wird.

Fig. 3 zeigt im Prinzip den Temperaturverlauf von oben nach unten im unteren Teil des Schmelztiegel 10 und im nach unten anschließenden oberen Bereich des Formschachts 14 bzw. 24, 26. Wie dargestellt, ist die Temperatur im Schmelztiegel im Bereich der Einlaßöffnung 18 niedriger als im obersten Bereich des Formschachts 14 bzw. 24, 26, wo die Temperaturkurve in Form einer Spitze die Schmelztemperatur des Halblei!ermaterials erreicht. Von dort aus weiter abwärts im Formschacht 14 bzw. 24, 26 fällt die Temperatur dann derart ab, daß das Halbleitermaterial in der Kristallisationszone im Formschacht erstarrt und zu dessen unteren Ende hin weiter abgekühlt wird, so daß es im festen Zustand nach unten aus dem Formschacht herausgezogen werden kann.

Die Unterkühlung der Schmelze am unteren Ende des sich vorzugsweise nach unten zum Formschacht 14 bzw. 24, 26 hin verjüngenden Schmelz tiegel 10 hat vor allem Bedeutung vor Beginn des Einkristall-Ziehvorgangs. Durch die Unterkühlung wird erreicht, daß die unterkühlte Schmelze zunächst noch nicht durch die entsprechend schmal gewählte, schlitzförmige Einlaßöffnung 18 in den Formschacht 14 bzw. 24, 26 eintritt. Dies geschieht erst, wenn die sich an der Einlaßöffnung 18 in den Formschacht 14, bzw. 24, 26 hinein vorwölbende unterkühlte Schmelze mit dem mittels der Halterung 16 von unten her durch den Formschacht eingeführten Impfkristall in Berührung kommt (in Fig. 1 ist die Vorwölbung der unterkühlten Schmelze gestrichelt gezeigt), der danach wieder langsam abgesenkt wird, wodurch die durch die Einlaßöffnung 18 in den Formschacht 14 bzw. 24, 26 eingetretene Schmelze in den Bereich höchster Temperatur gemäß Fig. 3 kommt und bei weiterem Absenken des Impfkristalls in der sich nach unten anschließenden Kristallisationszone im Formschacht 14 bzw. 29, 26 kristallisiert.

Durch die Unterkühlung der Schmelze im Bereich des Schmelztiegels 10 kann erreicht werden, daß die Schmelze infolge ihrer Oberflächenspannung nach der Kontaktierung mit dem Impfkristall nicht in der oberen Verlängerung 15 des Formschachts 14 bzw. 24, 26 aufsteigt, sondern auf dem in Fig. 1 gezeigten unteren Niveau verharrt. Es besteht aber auch die Möglichkeit, nach dem Heranführen des Imfkristalls von unten durch den Formschacht 14 bzw. 24, 26 an die an der Einlaßöffnung 18 im unterkühlten Zustand gehaltene Schmelze 12 die Temperatur auch im unteren Bereich des Schmelztiegels 10 auf die Schmelztemperatur zu erhöhen, denn es ist für die Kristallisation in der Kristallisationszone des Formschachts ohne Bedeutung, wie hoch die Schmelze in der oberen Verlängerung 15 des Formschachts steht. Diese könnte deshalb entfallen.

Nachdem der im Formschacht 14 bzw. 24, 26 entstehende Einkristall um eine bestimmte Länge nach unten gewachsen ist, kann er unterhalb der Kristallisationszone durch eine schlitzförmige Queröffnung 28 in einer Seitenwand des Formschachts 19 bzw. 24, 26 hindurch mittels einer Schneideinrichtung abgetrennt werden. Das Abschneiden könnte auch unterhalb des Formschachts erfolgen. Im letzteren Fall besteht die Möglichkeit, auch nach dem Abtrennen des Impfkristalls und des unteren Endes des Einkristalls mittels einer Haltevorrichtung 16 weiterhin ein Zugkraft auf den oberen Teil des Einkristalls auszuüben.

Bei einem Übergang auf die Herstellung von einkristallinen Halbleiterplatten aus demselben Material, aber mit anderer Orientierungsrichtung kann der im Formschacht 14 bzw. 24, 26 befindliche Einkristall mittels eines anderen Impfkristalls von unten nach oben in die Schmelze zurückgeschoben und wieder aufgeschmolzen werden, wobei der neue Impfkristall nur soweit im Formschacht 14 bzw. 24, 26 hochgeschoben zu werden braucht, bis der frühere Einkristall vollständig aufgeschmolzen ist und beim Wiederabsenken des Impfkristalls durch die Kristallisationszone im Formschacht hindurch ein neuer Einkristall am jeweils leistenförmigen Impfkristall anwächst.

In der Kristallisationszone des Formschachts 14 bzw. 24, 26 findet ein Kristallisations- und gleichzeitig ein Formvorgang statt, bei welchem sich das erstarrende Halbleitermaterial der äußeren Form und der Oberflächengestalt der Innenwand des Formschachts anpaßt. Wenn diese erfindungsgemäß mit optischer Güte, d. h. minimaler Oberflächenrauhigkeit hergestellt ist, hat auch der im Formschacht gebildete Einkristall eine entsprechende Oberfläche und braucht nicht mehr oder nur minimal nachgearbeitet zu werden. Wesentlich ist, daß die Kristallstruktur durchgehend bis zur Oberfläche vorhanden ist.

## Patentansprüche

1. Verfahren zur Herstellung von einkristallinen Halbleiterplatten, z. B. Wafern, durch Züchtung eines Einkristalls mittels eines Impfkristalls aus einer Schmelze und Abtrennung der einzelnen Halbleiterplatten von dem Einkristall, wobei die Schmelze in einem unterhalb ihrer Oberfläche über eine Einlaßöffnung an einen Schmelztiegel angeschlossenen, in Längsrichtung glattwandigen Formschacht zur Kristallisation gebracht und der gebildete Einkristall weiter wachsend im Formschacht vorgeschoben und jeweils im Abstand der Länge einer Außenkante der Halbleiterplatten quer zur Vorschubrichtung durchgetrennt wird, **dadurch gekennzeichnet,** daß die Schmelze im Bereich zwischen der Einlaßöffnung (18) und der Kristallisationszone im Formschacht (14; 24, 26) auf eine höhere Temperatur als an der Einlaßöffnung (18) erhitzt wird und die Breite des Formschachts (14; 24, 26) gleich der Dicke der Halbleiterplatten ist.

2. Verfahren nach Anspruch 1, **dadurch gekennzeichnet,** daß die Vorschubgeschwindigkeit durch Zurückziehen einer Halterung des Impfkristalls oder des freien Endes des Einkristalls in Richtung von der Schmelze weg gesteuert wird.

3. Verfahren nach Anspruch 1 oder 2, **dadurch gekennzeichnet,** daß vor Beginn eines Kristallisationsvorgangs die Schmelze an der Einlaßöffnung in den Formschacht derart unterkühlt wird, daß sie durch ihre Oberflächenspannung dort zurückgehalten wird, bis sie mit dem Impfkristall in Berührung kommt.

4. Verfahren nach einem der Ansprüche 1 bis 3, **dadurch gekennzeichnet,** daß die Schmelze über die Einlaßöffnung seitlich in den oberhalb derselben offenen, im wesentlichen senkrecht ausgebildeten Formschacht eingeführt wird.

5. Verfahren nach einem der Ansprüche 1 bis 4, **dadurch gekennzeichnet**, daß wenigstens zwei jeweils durch eine Zwischenwand getrennte Einkristalle gleichzeitig gezüchtet werden.

6. Verfahren nach einem der Ansprüche 1 bis 5, **dadurch gekennzeichnet**, daß nach dem Abtrennen einer Halbleiterplatte zum Übergang auf die Herstellung von Halbleiterplatten mit anderer Kristallorientierung der mit der Schmelze in Berührung stehende Teil des Einkristalls über einen gegen sein äußeres Ende drückenden Impfkristall mit anderer Kristallorientierung im Formschacht rückwärts durch die Kristallisationszone hindurch in die Schmelze geschoben und wieder aufgeschmolzen wird.

7. Vorrichtung zur Durchführung des Verfahrens nach einem der Ansprüche 1 bis 6 mit einem Schmelztiegel (10), an den unterhalb der Oberfläche der Schmelze (12) über eine Einlaßöffnung (18) wenigstens ein in Längsrichtung glattwandiger Formschacht (14; 24, 26) angeschlossen ist, in welchem eine Halterung (16) für einen Impfkristall vom offenen Ende zum Schmelztiegel (10) hin vorschiebbar und zurückziehbar ist, **dadurch gekennzeichnet**, daß der Formschacht (14; 24, 26) durch eine Hochfrequenzspule (20) mit einem zwischen der Einlaßöffnung (18) und der Kristallisationszone angeordneten Konzentrator (22) auf eine höhere Temperatur als an der Einlaßöffnung (18) beheizbar ist.

8. Vorrichtung nach Anspruch 7, **dadurch gekennzeichnet**, daß der Formschacht (14; 24, 26) oder die Halterung (16) für den Impfkristall wenigstens einen Entgasungskanal (15) enthalten, durch welchen beim Vorschieben des Impfkristalls im Formschacht (14; 24, 26) das zwischen dem Impfkristall und der Schmelze (12) eingeschlossene Gas entweicht.

9. Vorrichtung nach Anspruch 8, **dadurch gekennzeichnet,** daß der Formschacht (14, 15; 24, 26) im wesentlichen senkrecht ausgerichtet und oberhalb der seitlich angeordneten Einlaßöffnung (18) zur umgebenden Atmosphäre offen ist.

10. Vorrichtung nach Anspruch 9, **dadurch gekennzeichnet,** daß sich der Formschacht(14, 15; 24, 26) bis über die Oberfläche der Schmelze (12) nach oben erstreckt.

11. Vorrichtung nach einem der Ansprüche 7 bis 10, **dadurch gekennzeichnet**, daß wenigstens zwei Formschächte (24, 26) unmittelbar nebeneinander angeordnet und durch eine gemeinsame Hochfrequenzspule (20, 22) beheizbar sind.

12. Vorrichtung nach einem der Ansprüche 7 bis 11, **dadurch gekennzeichnet**, daß zur Herstellung von Siliciumplatten die Innenwand des Schmelztiegels (10) aus Quarz und die Innenwand des Formschachts (14; 24, 26) wenigstens im Bereich der Kristallisationszone aus einem Edelmetall besteht.

13. Vorrichtung nach einem der Ansprüche 7 bis 12, **dadurch gekennzeichnet**, daß die Oberfläche der Innenwand des Formschachts (14; 24, 26) wenigstens im Bereich der Kristallisationszone mit optischer Güte feinstbearbeitet ist.


## Claims

1. A process for manufacturing monocrystalline semiconductor plates, e.g. wafers, by growing a single crystal from a melt by means of a seed crystal and detaching the individual semiconductor plates from the single crystal, wherein the melt is caused to crystallise in a forming shaft which is attached below the surface of the melt to a melting crucible via an inlet opening and which forming shaft is smooth-walled in the longitudinal direction, and the crystal formed is advanced growing further in the forming shaft and is severed in each case transverse to the direction of advance at the distance of the length of an outer edge of the semiconductor plates, characterised in that the melt in the region between the inlet opening (18) and the crystallisation zone in the forming shaft (14; 24, 26) is heated to a higher temperature than at the inlet opening (18), and the width of the forming shaft (14; 24, 26) is equal to the thickness of the semiconductor plates.

2. A process according to Claim 1, characterised in that the rate of advance is controlled by withdrawing a support for the seed crystal or the free end of the single crystal in the direction away from the melt.

3. A process according to Claims 1 or 2, characterised in that before the start of a crystallisation process the melt at the inlet opening in the forming shaft is under-cooled in such a way that it is held back there by its surface tension until it comes into contact with the seed crystal.

4. A process according to any one of Claims 1 to 3, characterised in that the melt is fed laterally via the inlet opening into the forming shaft, which is open at its top and which is formed substantially vertically.

5. A process according to any one of Claims 1 to 4, characterised in that at least two single crystals are grown simultaneously, each of which is separated by a partition wall.

6. A process according to any one of Claims 1 to 5, characterised in that, after detaching a semiconductor plate and to change over to the manufacture of semiconductor plates with another crystal orientation, the part of the single crystal which remains in contact with the melt is moved backwards in the forming shaft through the crystallisation zone into the melt by means of a seed crystal pressing against its outer end, and re-melted.

7. A device for carrying out the process according to any one of Claims 1 to 6 with a melting crucible (10), to which at least one forming shaft (14; 24, 26) which is smooth-walled in the longitudinal direction is attached beneath the surface of the melt (12) via an inlet opening (18), in which forming shaft a support (16) for a seed crystal can be moved backwards and forwards from the open end to the melting crucible (10), characterised in that the forming shaft (14; 24, 26) can be heated to a higher temperature than that of the inlet opening (18) by means of a high-frequency coil (20) with a concentrator (22) disposed between the inlet opening (18) and the crystallisation zone.

8. A device according to Claim 7, characterised in that the forming shaft (14; 24, 26) or the support (16) for the seed crystal contains at least one degassing channel (15), through which the gas confined between the seed crystal and the melt (12) escapes on advancing the seed crystal in the forming shaft (14; 24, 26).

9. A device according to Claim 8, characterised in that the forming shaft (14, 15; 24, 26) is aligned substantially vertically and is open to the surrounding atmosphere above the laterally disposed inlet opening (18).

10. A device according to Claim 9, characterised in that the forming shaft (14, 15; 24, 26) extends upwards

EP 0 386 047 B1

above the surface of the melt (12).

11. A device according to any one of Claims 7 to 10, characterised in that at least two forming shafts (24, 26) are disposed directly adjacent to each other and can be heated by a common high-frequency coil (20, 22) .

12. A device according to any one of Claims 7 to 11, characterised in that for the manufacture of silicon plates the inside wall of the melting crucible (10) consists of quartz and the inside wall of the forming shaft (14; 24, 26) consists of a noble metal, at least in the region of the crystallisation zone.

13. A device according to any one of Claims 7 to 12, characterised in that the surface of the inside wall of the forming shaft (14; 24, 26) is micro-finished to optical quality, at least in the region of the crystallisation zone.

## Revendications

1. Procédé pour la fabrication de plaquettes semi-conductrices monocristallines, par exemple des plaquettes de support, par développement d'un monocristal à l'aide d'un cristal d'inoculation, à partir d'un bain en fusion et séparation des différentes plaquettes semi-conductrices du monocristal, le bain étant mis pour la cristallisation dans un puits de formation à paroi lisse dans la direction longitudinale, raccordé par un orifice d'entrée à un creuset de fusion en-dessous de la surface du bain et le monocristal ainsi formé continuant à croître étant avancé dans le puits de formation jour être coupé transversalement à la direction de poussée, à un intervalle correspondant à la longueur d'un côté extérieur des plaquettes semi-conductrices, procédé caractérisé en ce que le bain est réchauffé dans la zone comprise entre l'orifice d'entrée (18) et la zone de cristallisation dans le puits de formation (14 ; 24, 26) à une température supérieure à celle au niveau de l'orifice d'entrée (18) et en ce que la largeur du puits de formation (14 ; 24, 26) est égale à l'épaisseur des plaquettes semi-conductrices.

2. Procédé selon la revendication 1, caractérisé en ce que la vitesse d'avancement se commande par le retrait d'un support du cristal d'inoculation ou de l'extrémité libre du monocristal dans la direction s'écartant du bain.

3. Procédé selon la revendication 1 ou 2, caractérisé en ce qu'avant le début d'une opération de cristallisation le bain est refroidi au niveau de l'orifice d'entrée dans le puits de formation pour y rester accroché par sa tension de surface jusqu'à ce qu'il arrive en contact avec le cristal d'inoculation.

4. Procédé selon l'une des revendications 1 à 3, caractérisé en ce que le bain est introduit dans le puits de formation essentiellement vertical, ouvert dans sa partie supérieure, latéralement par l'orifice d'entrée.

5. Procédé selon l'une des revendications 1 à 4, caractérisé en ce qu'on développe simultanément au moins deux monocristaux séparés par une cloison.

6. Procédé selon l'une des revendications 1 à 5, caractérisé en ce qu'après la séparation d'une plaque semi-conductrice au passage à la fabrication de plaques semi-conductrices avec une autre orientation du cristal, la partie du monocristal en contact avec le bain est poussée dans le bain par un cristal d'inoculation appuyant contre son extrémité extérieure, avec une autre orientation de cristal, en reculant dans le puits de formation, à travers la zone de cristallisation pour être de nouveau fondue.

7. Dispositif pour la mise en oeuvre du procédé selon l'une des revendications 1 à 6, comportant un creuset de fusion (10) auquel est relié un puits de formation (14 ; 24, 26) à paroi lisse dans la direction longitudinale, par un orifice d'entrée (18) situé en-dessous de la surface du bain (12), puis dans lequel peut avancer et reculer un support (16) pour un cristal d'inoculation à partir de l'extrémité ouverte vers le creuset (10), dispositif caractérisé en ce que le puits de formation (14 ; 24, 26) est chauffé par une bobine à haute fréquence (20) avec un concentrateur (22) prévu entre l'orifice d'entrée (18) et la zone de cristallisation pour arriver à une température supérieure à celle au niveau de l'orifice d'entrée (18).

8. Dispositif selon la revendication 7, caractérisé en ce que le puits de formation (14 ; 24, 26) ou le support (16) du cristal d'inoculation contiennent au moins un canal de dégazage (15) à travers lequel, lors de l'avancée du cristal d'inoculation dans le puits de formation (14 ; 24, 26), s'échappe le gaz emprisonné entre le cristal d'inoculation et le bain (12).

9. Dispositif selon la revendication 8, caractérisé en ce que le puits de formation (14, 15 ; 24, 26) est aligné essentiellement verticalement et est ouvert à l'atmosphère ambiante au-dessus de l'orifice d'entrée (18) placé latéralement.

10. Dispositif selon la revendication 9, caractérisé en ce que le puits de formation (14, 15 ; 24, 26) remonte jusqu'au-dessus de la surface du bain (12).

11. Dispositif selon l'une des revendications 7 à 10, caractérisé en ce qu'au moins deux puits de formation (24, 26) sont directement juxtaposés et sont chauffés par une bobine à haute fréquence (20, 22) commune.

12. Dispositif selon l'une des revendications 7 à 11, caractérisé en ce que pour fabriquer des plaquettes de silicium, la paroi intérieure du creuset (10) est en quartz et la paroi intérieure du puits de formation (14 ;

24, 26) est en un métal noble au moins au niveau de la zone de cristallisation.

13. Dispositif selon l'une des revendications 7 à 12, caractérisé en ce que la surface de la paroi intérieure du puits de formation (14 ; 24, 26) est traitée en usinage fin de qualité optique au moins dans la zone de cristallisation.

Fig. 1

Temp.

Fig. 3

Tiegel          Formschacht

18

28

24

26

Fig. 2